# EUROPEAN PATENT APPLICATION

(11) **EP 4 534 738 A1**
(43) Date of publication of application: **09.04.2025**
(21) Application number: 23815917.2
(22) Date of filing: 25.05.2023
(51) Int. Cl.: C30B 25/12, C30B 29/36, C23C 16/458, H01L 21/205, H01L 21/683

(54) **HOLDER AND VAPOR PHASE GROWTH APPARATUS**

(30) Priority: 30.05.2022 JP 2022087517
(71) Applicant: NuFlare Technology, Inc., Yokohama-shi, Kanagawa 235-8522 (JP)
(72) Inventor: WATANABE, Toru, Yokohama-shi, Kanagawa 235-8522 (JP); DAIGO, Yoshiaki, Yokohama-shi, Kanagawa 235-8522 (JP); YAJIMA, Masayoshi, Yokohama-shi, Kanagawa 235-8522 (JP)
(74) Representative: Hoffmann Eitle
(86) International application number: PCT/JP2023/019456
(87) International publication number: WO 2023/234159

(57) **Abstract**

A holder according to an embodiment includes a portion containing non-oriented polycrystalline 3C-SiC on its surface, and a substrate can be placed on the holder.

## Description

### TECHNICAL FIELD

The present invention relates to a holder for placing a substrate thereon, which is used in a vapor phase growth apparatus for supplying a gas to the surface of the substrate to form a film, and the vapor phase growth apparatus.

### BACKGROUND ART

As a method of forming a high-quality semiconductor film, there is an epitaxial growth technique for forming a single crystal film on the surface of a substrate by vapor phase growth. In a vapor phase growth apparatus using the epitaxial growth technique, a substrate is placed on a holder in a chamber held at normal pressure or reduced pressure.

Then, a process gas containing a raw material for a semiconductor film is supplied to the chamber while heating the substrate. A chemical reaction of the process gas occurs on the surface of the substrate, so that an epitaxial single crystal film is formed on the surface of the substrate.

After the epitaxial single crystal film is formed on the surface of the substrate, a large deformation may be observed in the holder on which the substrate is placed. The deformation of the holder may cause problems, such as damage to the holder or errors in transferring the holder.

### CITATION LIST

### PATENT DOCUMENT

Patent Document 1: JP 2011-243710 A

### SUMMARY OF THE INVENTION

### PROBLEM TO BE SOLVED BY THE INVENTION

A problem to be solved by the invention is to provide a holder capable of suppressing its deformation.

### MEANS FOR SOLVING PROBLEM

A holder according to an aspect of the invention includes a portion containing non-oriented polycrystalline 3C-SiC on its surface, and a substrate can be placed on the holder.

A vapor phase growth apparatus according to an aspect of the invention includes the holder according to the aspect described above.

### EFFECT OF THE INVENTION

According to the invention, it is possible to realize a holder capable of suppressing its deformation and a vapor phase growth apparatus.

### BRIEF DESCRIPTION OF DRAWINGS

Fig. 1 is a schematic cross-sectional view of a vapor phase growth apparatus according to a first embodiment;
Fig. 2 is a schematic diagram of a holder according to the first embodiment;
Fig. 3 is a schematic diagram of a holder according to a modification example of the first embodiment;
Fig. 4 is a diagram showing Out-of-Plane XRD measurement results of annular members according to the first embodiment and a comparative example;
Fig. 5 is a diagram showing measurement results of a silicon carbide film formed on the surface of an annular member according to the comparative example by Raman spectroscopy;
Fig. 6 is a diagram showing measurement results of a silicon carbide film formed on the surface of the annular member according to the first embodiment by Raman spectroscopy;
Fig. 7 is a schematic diagram of a holder according to a second embodiment;
Fig. 8 is a schematic diagram of a holder according to a modification example of the second embodiment; and
Fig. 9 is a schematic diagram of a holder according to a third embodiment.

### MODE(S) FOR CARRYING OUT THE INVENTION

Hereinafter, embodiments of the invention will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. Then, "upper" means a position in a direction opposite to the direction of gravity with respect to the reference, and "upward" means a direction opposite to the direction of gravity with respect to the reference. In addition, the "vertical direction" is the direction of gravity.

In addition, in this specification, "process gas" is a general term for gases used for forming a film, and is a concept including, for example, a source gas, an assist gas, a dopant gas, a carrier gas, and a mixed gas thereof.

### (First Embodiment)

A holder according to a first embodiment includes a portion containing non-oriented polycrystalline 3C-SiC on its surface, and a substrate can be placed on the holder. In addition, a vapor phase growth apparatus according to the first embodiment includes a portion containing non-oriented polycrystalline 3C-SiC on its surface, and includes a holder on which a substrate can be placed.

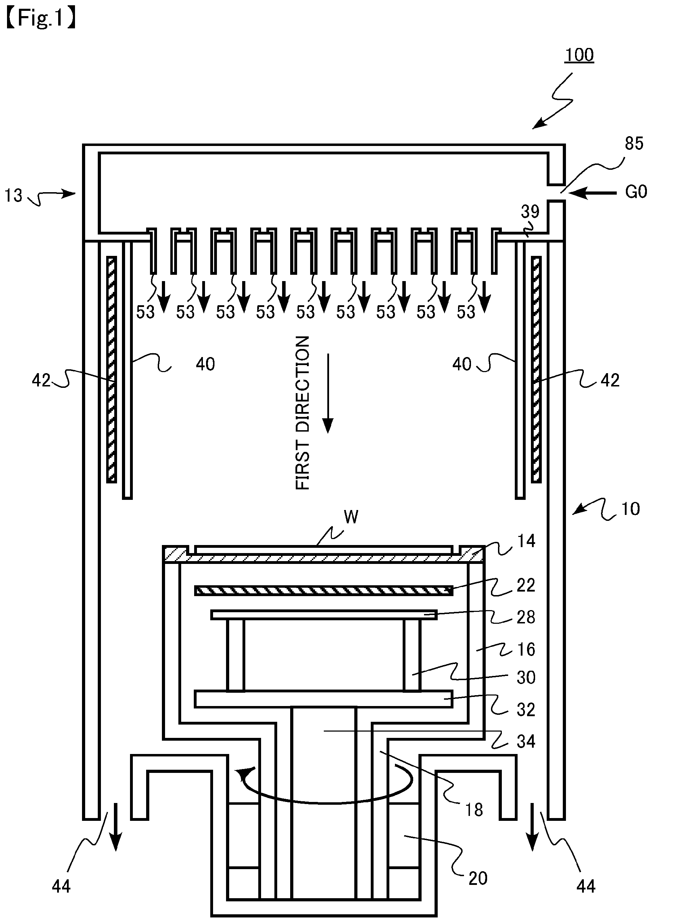

Fig. 1 is a schematic cross-sectional view of the vapor phase growth apparatus according to the first embodiment. A vapor phase growth apparatus 100 according to the first embodiment is, for example, a single wafer type epitaxial growth apparatus for epitaxially growing a single crystal silicon carbide film (SiC film) on the surface of a single crystal silicon carbide substrate.

The vapor phase growth apparatus 100 according to the first embodiment includes a chamber 10 and a buffer chamber 13. The chamber 10 includes a susceptor 14 (holder), a rotating body 16, a rotating shaft 18, a rotation driving mechanism 20, a first heater 22, a reflector 28, a support column 30, a fixed base 32, a fixed shaft 34, a hood 40, a second heater 42, a gas discharge port 44, and a gas conduit 53. The buffer chamber 13 includes a partition plate 39 and a gas supply port 85.

The chamber 10 is formed of stainless steel, for example. The chamber 10 has a cylindrical wall. In the chamber 10, a single crystal silicon carbide film is formed on the surface of a wafer W. The wafer W is an example of a substrate. The wafer W is, for example, a semiconductor wafer. The wafer W is, for example, a single crystal silicon carbide wafer.

The susceptor 14 is provided in the chamber 10. The wafer W can be placed on the susceptor 14. The susceptor 14 is an example of a holder.

The susceptor 14 is formed of a highly heat-resistant material, such as silicon carbide, graphite, tantalum carbide, or graphite coated with pyrolytic graphite or the like.

The susceptor 14 is placed on the rotating body 16. The rotating body 16 is fixed to the rotating shaft 18. The susceptor 14 is indirectly fixed to the rotating shaft 18.

The rotating shaft 18 can be rotated by the rotation driving mechanism 20. By rotating the rotating shaft 18, it is possible to rotate the susceptor 14. By rotating the susceptor 14, it is possible to rotate the wafer W placed on the susceptor 14.

Due to the rotation driving mechanism 20, for example, the wafer W can be rotated at a rotation speed of 1 rpm or more and 3000 rpm or less. The rotation driving mechanism 20 is formed by, for example, a motor and a bearing.

The first heater 22 is provided below the susceptor 14. The first heater 22 is provided in the rotating body 16. The first heater 22 heats the wafer W placed on the susceptor 14 from below. The first heater 22 is, for example, a resistor heater. The first heater 22 has, for example, a disc shape with a comb-shaped pattern.

The reflector 28 is provided below the first heater 22. The first heater 22 is provided between the reflector 28 and the susceptor 14.

The reflector 28 reflects the heat radiated downward from the first heater 22 to improve the heating efficiency of the wafer W. In addition, the reflector 28 prevents the members below the reflector 28 from being heated. The reflector 28 has, for example, a disk shape. The reflector 28 is formed of a highly heat-resistant material such as silicon carbide, graphite, tantalum carbide, and graphite coated with pyrolytic graphite or the like.

The reflector 28 is fixed to the fixed base 32 by, for example, a number of support columns 30. The fixed base 32 is supported by, for example, the fixed shaft 34.

In order to attach and detach the susceptor 14 to and from the rotating body 16, a lift pin (not shown) is provided in the rotating body 16. The lift pin penetrates, for example, the reflector 28 and the first heater 22.

The second heater 42 is provided between the hood 40 and the inner wall of the chamber 10. The second heater 42 is located above the susceptor 14.

The second heater 42 heats the wafer W placed on the susceptor 14 from above. By heating the wafer W with the second heater 42 in addition to the first heater 22, it is possible to easily heat the wafer W to a temperature required for the growth of the silicon carbide film, for example, a temperature of 1500°C or higher. The second heater 42 is, for example, a resistor heater.

The hood 40 has, for example, a cylindrical shape. The hood 40 has a function of preventing a first process gas G1 or a second process gas G2 from coming into contact with the second heater 42. The hood 40 is formed of a highly heat-resistant material such as graphite or graphite coated with silicon carbide.

The gas discharge port 44 is provided at the bottom of the chamber 10. The gas discharge port 44 discharges by-products generated after the source gas reacts on the surface of the wafer W and a surplus process gas to the outside of the chamber 10. The gas discharge port 44 is connected to, for example, a vacuum pump (not shown).

In addition, a susceptor loading/unloading port and a gate valve (neither of which are shown) are provided in the chamber 10. Due to the susceptor loading/unloading port and the gate valve, the susceptor 14 on which the wafer W is placed can be loaded into the chamber 10 or unloaded out of the chamber 10.

The buffer chamber 13 is provided on the chamber 10. The gas supply port 85 for introducing the process gas G0 is provided in the buffer chamber 13. The process gas G0 introduced from the gas supply port 85 is filled in the buffer chamber 13.

The process gas G0 is, for example, a mixed gas containing a source gas of silicon (Si), a source gas of carbon (C), a dopant gas of n-type impurities, a dopant gas of p-type impurities, an assist gas for suppressing silicon clustering, and a carrier gas. The silicon source gas is, for example, a silane gas (SiH₄). The carbon source gas is, for example, a propane gas (C₃H₈). The dopant gas of n-type impurities is, for example, a nitrogen gas (N₂). The dopant gas of p-type impurities is, for example, a trimethylaluminum gas (TMA). The assist gas is, for example, a hydrogen chloride gas (HCl). The carrier gas is, for example, an argon gas (Ar) or a hydrogen gas (H₂).

A plurality of gas conduits 53 are provided between the buffer chamber 13 and the chamber 10. The gas conduit 53 extends in a first direction from the buffer chamber 13 toward the chamber 10. The plurality of gas conduits 53 supply the process gas G0 from the buffer chamber 13 to the chamber 10.

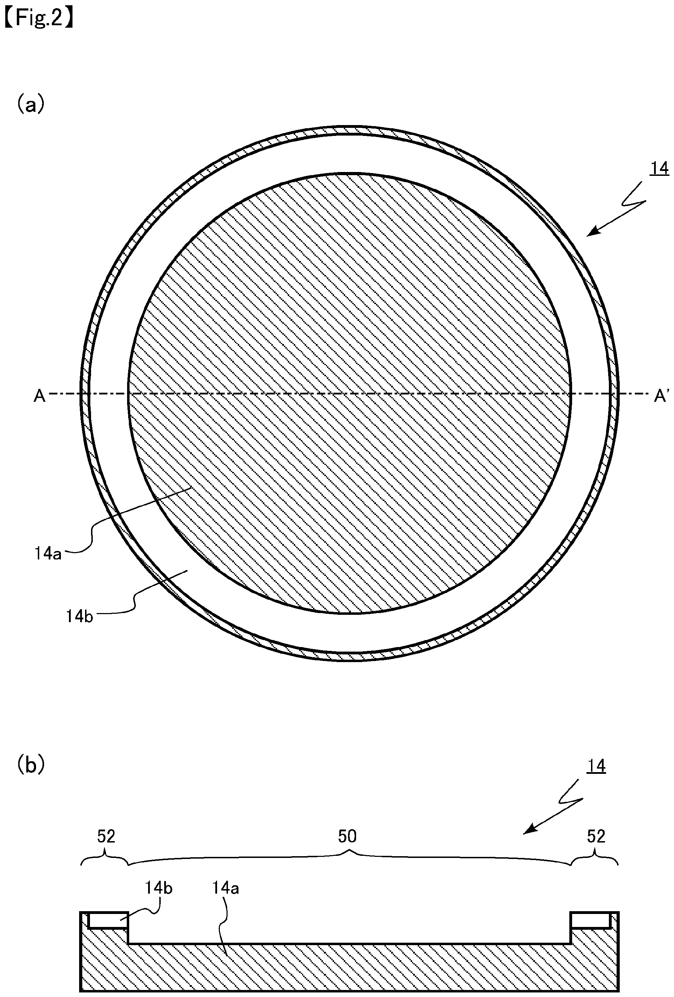

Fig. 2 is a schematic diagram of the holder according to the first embodiment. Fig. 2(a) is a top view, and Fig. 2(b) is a cross-sectional view taken along the line AA' of Fig. 2(a).

The susceptor 14 includes an inner region 50 and an outer region 52. The outer region 52 surrounds the inner region 50. The outer region 52 surrounds the wafer W when the wafer W is placed on the susceptor 14.

The inner region 50 has a disc shape. The outer region 52 has an annular shape. The inner region 50 is a recessed portion that is recessed with respect to the outer region 52.

The susceptor 14 includes a base member 14a and an annular member 14b.

The base member 14a has a disc shape. The base member 14a is provided in the inner region 50 and the outer region 52. The base member 14a supports the bottom surface of the wafer W when the wafer W is placed on the susceptor 14.

The base member 14a is, for example, graphite.

The annular member 14b has an annular shape. The annular member 14b has, for example, a circular ring shape. The annular member 14b is provided in the outer region 52. The annular member 14b is placed, for example, on the base member 14a in the outer region 52. The annular member 14b is placed, for example, on the outer periphery of the base member 14a in the outer region 52. The position of the annular member 14b on the base member 14a is fixed by, for example, a protrusion provided on the outer periphery of the base member 14a. The annular member 14b has an anti-adhesion function for preventing a film from adhering to the base member 14a on the lower side when the film is formed on the wafer surface.

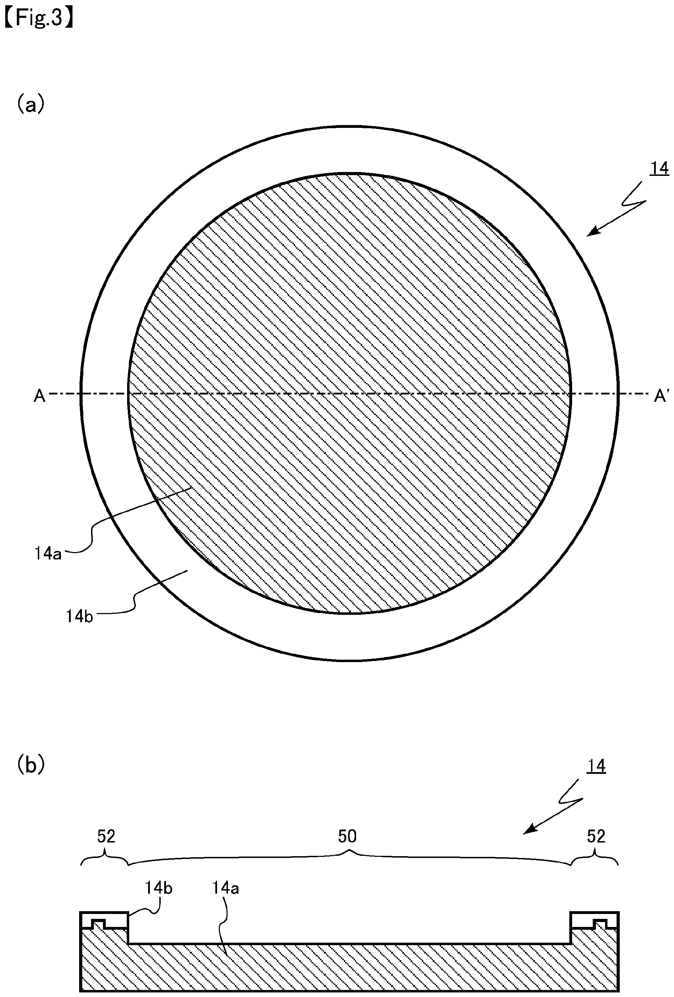

Fig. 3 is a schematic diagram of a holder according to a modification example of the first embodiment. Fig. 3(a) is a top view, and Fig. 3(b) is a cross-sectional view taken along the line AA' of Fig. 3(a).

The protrusion provided on the outer periphery of the base member 14a may be located below the annular member 14b as shown in Fig. 3.

The annular member 14b contains non-oriented polycrystalline 3C-SiC. The term "non-oriented" means that the crystal orientations of the single crystal domains forming the polycrystal is random. The annular member 14b contains non-oriented polycrystalline 3C-SiC on its surface.

The annular member 14b is mainly formed of polycrystalline 3C-SiC. For example, the volume percentage of polycrystalline 3C-SiC contained in the annular member 14b is greater than the volume percentage of other materials contained in the annular member 14b. For example, the volume percentage of polycrystalline 3C-SiC contained in the annular member 14b is greater than the volume percentage of polycrystalline 4H-SiC contained in the annular member 14b. In addition, for example, the volume percentage of polycrystalline 3C-SiC contained in the annular member 14b is greater than the volume percentage of amorphous SiC contained in the annular member 14b.

The occupancy rate of polycrystalline 3C-SiC on the surface of the annular member 14b is, for example, 80% or more.

At least the surface of the annular member 14b is formed of non-oriented polycrystalline 3C-SiC. The annular member 14b is an example of a portion containing non-oriented polycrystalline 3C-SiC on its surface.

The annular member 14b is formed of, for example, a single material. For example, the annular member 14b is formed of non-oriented polycrystalline 3C-SiC.

The annular member 14b can be formed of a material different from a material forming the base member 14a, for example.

In the non-oriented polycrystalline 3C-SiC contained in the annular member 14b, assuming that the diffraction peak intensity of the (111) face of the 3C-SiC obtained by Out-of-Plane X-ray diffraction (XRD) measurement is 100, the diffraction peak intensity of the (200) face of the 3C-SiC is 10 or more and 40 or less, the diffraction peak intensity of the (220) face of the 3C-SiC is 25 or more and 50 or less, and the diffraction peak intensity of the (311) face of the 3C-SiC is 15 or more and 65 or less.

In addition, in the non-oriented polycrystalline 3C-SiC contained in the annular member 14b, for example, assuming that the diffraction peak intensity of the (111) face of the 3C-SiC obtained by Out-of-Plane XRD measurement is 100, the diffraction peak intensity of the (400) face of the 3C-SiC is 0 or more and 20 or less, the diffraction peak intensity of the (331) face of the 3C-SiC is 0 or more and 20 or less, the diffraction peak intensity of the (420) face of the 3C-SiC is 0 or more and 20 or less, and the diffraction peak intensity of the (422) face of the 3C-SiC is 0 or more and 20 or less. For example, the diffraction peak intensity of the (400) face of the 3C-SiC is greater than 0, the diffraction peak intensity of the (331) face of the 3C-SiC is greater than 0, the diffraction peak intensity of the (420) face of the 3C-SiC is greater than 0, and the diffraction peak intensity of the (422) face of the 3C-SiC is greater than 0.

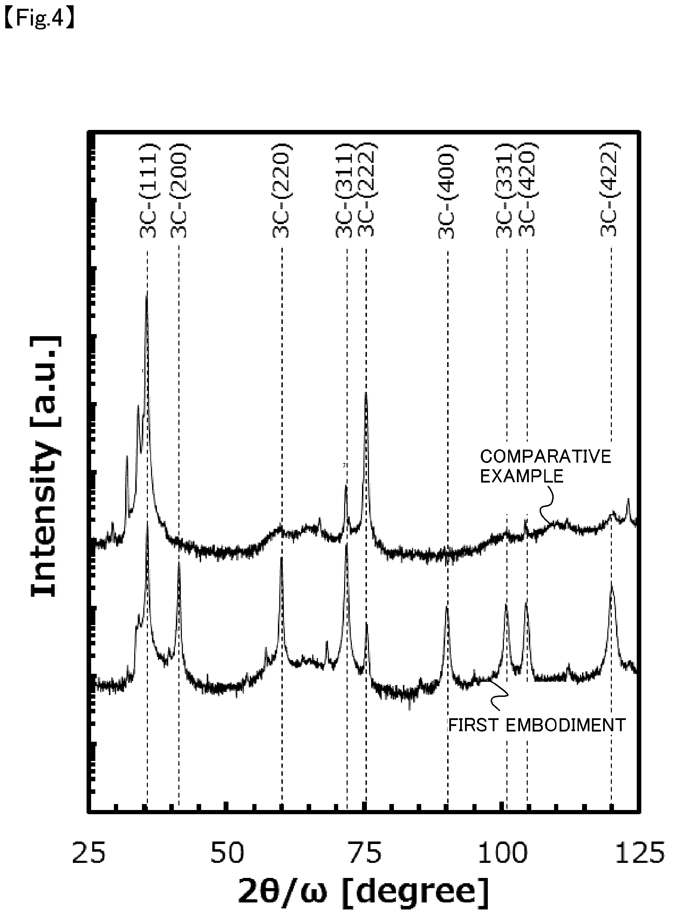

Fig. 4 is a diagram showing Out-of-Plane XRD measurement results of annular members according to the first embodiment and a comparative example. The annular member according to the comparative example is formed of (111) oriented polycrystalline 3C-SiC. In Fig. 4, an upper XRD pattern is the measurement result of the annular member according to the comparative example, and a lower XRD pattern is the measurement result of the annular member according to the first embodiment.

As shown in Fig. 4, in the case of the annular member according to the first embodiment, the diffraction peak of the (111) face of the 3C-SiC obtained by Out-of-Plane XRD measurement is observed to be the strongest compared to other peaks. In addition, the diffraction peak of the (200) face of the 3C-SiC, the diffraction peak of the (220) face of the 3C-SiC, and the diffraction peak of the (311) face of the 3C-SiC are observed to be weaker than the diffraction peak of the (111) face of the 3C-SiC. In addition, the diffraction peak of the (400) face of the 3C-SiC, the diffraction peak of the (331) face of the 3C-SiC, the diffraction peak of the (420) face of the 3C-SiC, and the diffraction peak of the (422) face of the 3C-SiC are observed to be weaker than the diffraction peak of the (200) face of the 3C-SiC, the diffraction peak of the (220) face of the 3C-SiC, and the diffraction peak of the (311) face of the 3C-SiC. This relationship in magnitude between the peaks is similar to the XRD pattern at the time of XRD measurement of 3C-SiC powder, and indicates that the annular member according to the first embodiment is not in a specific orientation state, that is, is non-oriented. More specifically, in the case of the diffraction peak intensity of the XRD pattern for the annular member according to the first embodiment, assuming that the diffraction peak intensity of the (111) face of the 3C-SiC is 100, the diffraction peak intensity of the (200) face of the 3C-SiC is 10 or more and 40 or less, the diffraction peak intensity of the (220) face of the 3C-SiC is 25 or more and 50 or less, and the diffraction peak intensity of the (311) face of the 3C-SiC is 15 or more and 65 or less. In addition, the diffraction peak intensity of the (400) face of the 3C-SiC is greater than 0, the diffraction peak intensity of the (331) face of the 3C-SiC is greater than 0, the diffraction peak intensity of the (420) face of the 3C-SiC is greater than 0, and the diffraction peak intensity of the (422) face of the 3C-SiC is greater than 0.

On the other hand, as shown in Fig. 4, in the case of the annular member according to the comparative example, the diffraction peak intensity of the (111) face of the 3C-SiC and the diffraction peak intensity of the (222) face of the 3C-SiC obtained by Out-of-Plane XRD measurement can be mainly observed. In addition, the diffraction peaks of the (200) face of the 3C-SiC, the (220) face of the 3C-SiC, the (311) face of the 3C-SiC, the (400) face of the 3C-SiC, the (331) face of the 3C-SiC, the (420) face of the 3C-SiC, and the (422) face of the 3C-SiC can hardly be observed. That is, this indicates that the annular member according to the comparative example is formed of (111) oriented 3C-SiC.

When forming a silicon carbide film on the surface of the wafer W using the vapor phase growth apparatus 100, first, the susceptor 14 on which the wafer W is placed is loaded into the chamber 10. The susceptor 14 is placed on the rotating body 16.

The wafer W is heated by using the first heater 22 and the second heater 42. For example, the wafer W is heated to 1500°C or higher and 1800°C or lower. The process gas G0 is supplied from the buffer chamber 13 to the chamber 10 through a plurality of gas conduits 53.

By using the rotation driving mechanism 20, the rotating body 16 is rotated to rotate the susceptor 14. The wafer W placed on the susceptor 14 rotates together with the susceptor 14.

A single crystal silicon carbide film of, for example, 4H-SiC is formed on the surface of the rotating wafer W. At this time, the silicon carbide film is also formed on the surface of the annular member 14b placed on the outer periphery of the wafer W.

Next, the function and effect of the holder and the vapor phase growth apparatus according to the first embodiment will be described.

After forming a single crystal silicon carbide film on the surface of the wafer W placed on the susceptor, large deformation may be observed in the susceptor. For example, a large warpage in the susceptor may be observed.

When forming a single crystal silicon carbide film on the surface of the wafer W placed on the susceptor, for example, the silicon carbide film is formed on the surface of the outer peripheral region of the susceptor. For example, it is thought that the stress generated by the silicon carbide film formed on the surface of the outer peripheral area of the susceptor may cause large warpage in the susceptor. In addition, for example, it is thought that when forming a silicon carbide film, the introduction of distortion caused by heating the susceptor can cause large warpage in the susceptor.

If large warpage occurs in the susceptor, there is a risk that the susceptor will be damaged, for example. In addition, if large warpage occurs in the susceptor, there is a risk that a transferring error will occur when the susceptor is transferred, for example. Therefore, it is desirable to suppress the warpage of the susceptor.

The susceptor 14 according to the first embodiment includes a portion containing non-oriented polycrystalline 3C-SiC on its surface. Specifically, the surface of the annular member 14b provided in the outer region 52 of the susceptor 14 is formed of non-oriented polycrystalline 3C-SiC.

Since the surface of the annular member 14b is formed of non-oriented polycrystalline 3C-SiC, warpage of the susceptor 14 is suppressed. It is thought that one of the reasons is that the stress caused by the silicon carbide film formed on the surface of the outer region 52 of the susceptor 14 is reduced due to the surface of the annular member 14b formed of non-oriented polycrystalline 3C-SiC.

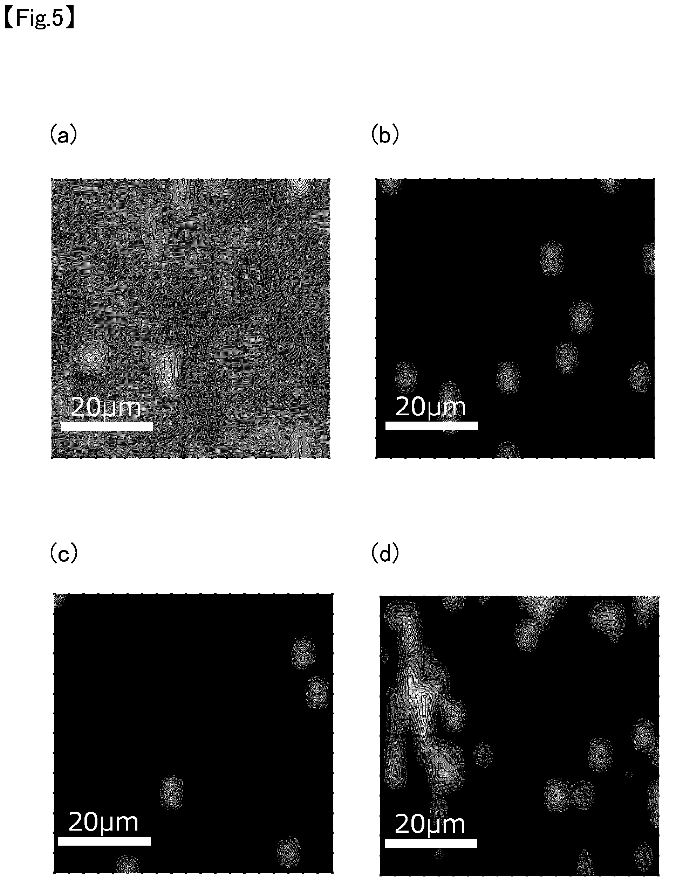

Fig. 5 is a diagram showing measurement results of a silicon carbide film formed on the surface of an annular member according to a comparative example by Raman spectroscopy. The annular member according to the comparative example has a surface formed of (111) oriented polycrystalline 3C-SiC. Fig. 5 shows the evaluation results of a silicon carbide film formed on the surface of an annular member placed on the outer periphery of the wafer W when a single crystal silicon carbide film of 4H-SiC is formed on the surface of the wafer W.

Fig. 5 shows the results of mapping, by Raman spectroscopy, the crystal state of the silicon carbide film formed on the surface of the annular member. Fig. 5(a) shows a peak detection result corresponding to 3C-SiC. Fig. 5(b) shows a peak detection result corresponding to 4H-SiC. Fig. 5(c) shows a peak detection result corresponding to amorphous SiC. Fig. 5(d) shows a peak detection result corresponding to 3C-SiC with distortion.

Fig. 5 shows the distribution of peaks corresponding to each crystal state. This shows that a region with a high white gradation is a region where there is SiC in the corresponding crystal state and there is no SiC in the corresponding crystal state in a black region.

As shown in Figs. 5(a), 5(b), 5(c), and 5(d), the silicon carbide film formed on the surface of the annular member according to the comparative example contains 4H-SiC or amorphous SiC, but 3C-SiC is widely distributed. In particular, as shown in Fig. 5(d), 3C-SiC with distortion is widely distributed.

The wide distribution of 3C-SiC with distortion in the silicon carbide film formed on the surface of the annular member suggests that the distortion of the annular member according to the comparative example is large. It was confirmed that large warpage occurred in the annular member according to the comparative example by placing the measured annular member according to the comparative example on a surface plate.

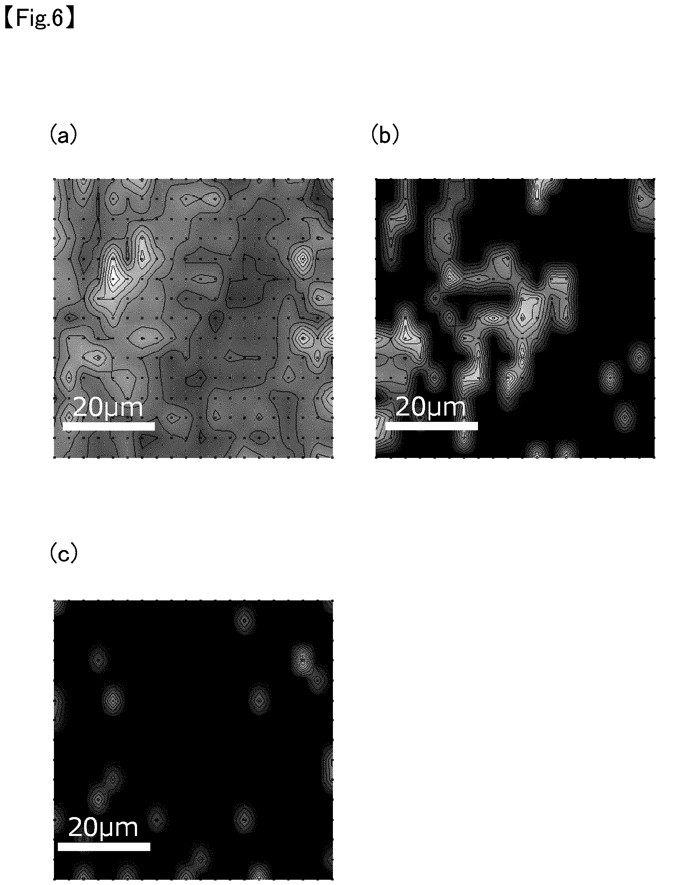

Fig. 6 is a diagram showing measurement results of a silicon carbide film formed on the surface of an annular member according to the first embodiment by Raman spectroscopy. The annular member 14b according to the first embodiment is formed of non-oriented polycrystalline 3C-SiC. Fig. 6 shows the evaluation results of a silicon carbide film formed on the surface of an annular member placed on the outer periphery of the wafer W when a single crystal silicon carbide film of 4H-SiC is formed on the surface of the wafer W.

Fig. 6 shows the results of mapping, by Raman spectroscopy, the crystal state of the silicon carbide film formed on the surface of the annular member. Fig. 6(a) shows a peak detection result corresponding to 3C-SiC. Fig. 6(b) shows a peak detection result corresponding to 4H-SiC. Fig. 6(c) shows a peak detection result corresponding to amorphous SiC.

Fig. 6 shows the distribution of peaks corresponding to each crystal state. This shows that a region with a high white gradation is a region where there is SiC in the corresponding crystal state and there is no SiC in the corresponding crystal state in a black region.

As shown in Figs. 6(a), 6(b), and 6(c), the silicon carbide film formed on the surface of the annular member 14b according to the first embodiment contains 3C-SiC widely distributed, similar to the annular member according to the comparative example. However, unlike the annular member according to the comparative example, no peaks corresponding to 3C-SiC with distortion were detected.

The fact that 3C-SiC with distortion was not detected in the silicon carbide film formed on the surface of the annular member 14b suggests that the distortion of the annular member 14b according to the first embodiment is small. It was confirmed that the warpage of the annular member 14b according to the first embodiment was significantly smaller than that of the annular member according to the comparative example by placing the measured annular member 14b according to the first embodiment on the surface plate.

As described above, according to the first embodiment, it is possible to provide a holder capable of suppressing its deformation and a vapor phase growth apparatus including the holder.

### (Second Embodiment)

A holder according to a second embodiment is different from the holder according to the first embodiment in that the inner region contains non-oriented polycrystalline 3C-SiC on its surface. Hereinafter, the description of the content overlapping the first embodiment will be omitted.

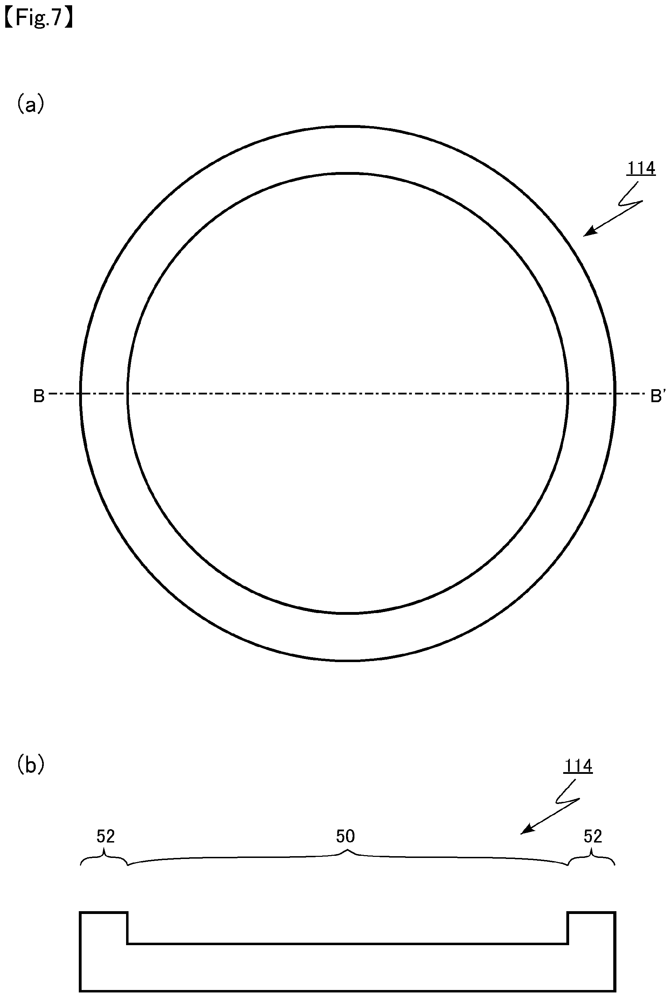

Fig. 7 is a schematic diagram of a holder according to the second embodiment. Fig. 7(a) is a top view, and Fig. 7(b) is a cross-sectional view taken along the line BB' of Fig. 7(a).

A susceptor 114 includes an inner region 50 and an outer region 52. The outer region 52 surrounds the inner region 50. The outer region 52 surrounds the wafer W when the wafer W is placed on the susceptor 114.

The inner region 50 has a disc shape. The outer region 52 has an annular shape. The inner region 50 is a recessed portion that is recessed with respect to the outer region 52.

The susceptor 114 contains non-oriented polycrystalline 3C-SiC on its surface. The inner region 50 and the outer region 52 of the susceptor 114 contain non-oriented polycrystalline 3C-SiC on at least their surfaces.

The susceptor 114 is formed of, for example, a single material. For example, the susceptor 114 is formed of non-oriented polycrystalline 3C-SiC.

Since the surface of the susceptor 114 according to the second embodiment is formed of non-oriented polycrystalline 3C-SiC, warpage of the susceptor 114 is suppressed.

### (Modification Example)

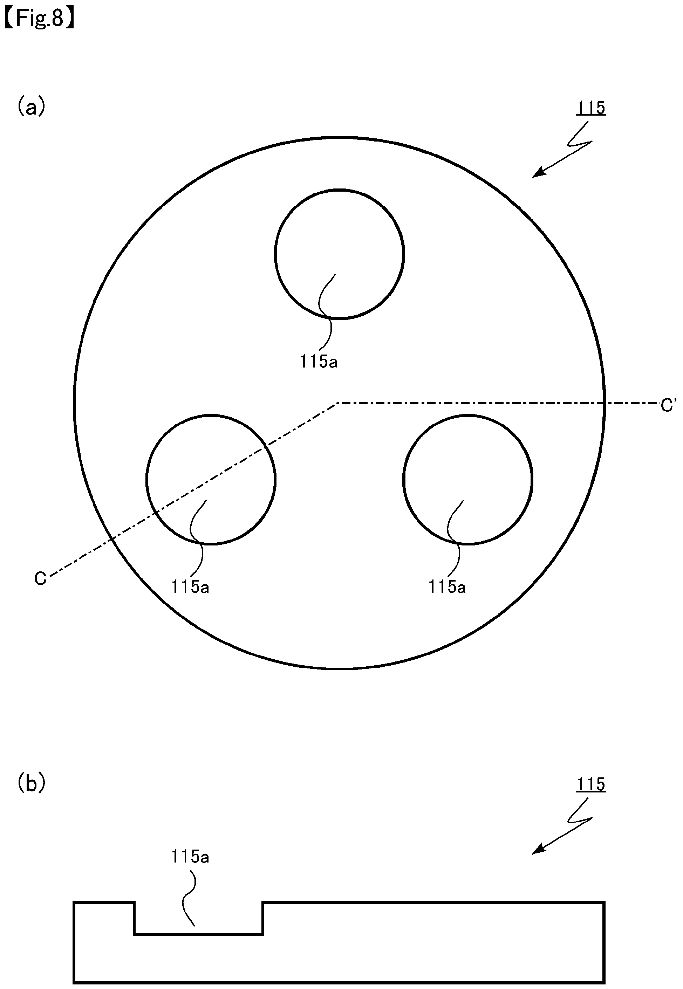

Fig. 8 is a schematic diagram of a holder according to a modification example of the second embodiment. Fig. 8(a) is a top view, and Fig. 8(b) is a cross-sectional view taken along the line CC' of Fig. 8(a).

A susceptor 115 is different from the susceptor 114 according to the second embodiment in that the susceptor 115 has three recessed portions 115a. Three of wafers W can be placed on the susceptor 115 at the same time.

Since the surface of the susceptor 115 according to the modification example of the second embodiment is formed of non-oriented polycrystalline 3C-SiC, warpage of the susceptor 115 is suppressed.

As described above, according to the second embodiment and its modification example, similarly to the first embodiment, it is possible to provide a holder capable of suppressing its deformation and a vapor phase growth apparatus including the holder.

### (Third Embodiment)

A holder according to a third embodiment is different from the holder according to the first embodiment in that an annular member includes a first member and a second member that can be separated from the first member and at least one of the first member and the second member includes a portion containing non-oriented polycrystalline 3C-SiC on its surface. Hereinafter, the description of the content overlapping the first embodiment will be omitted.

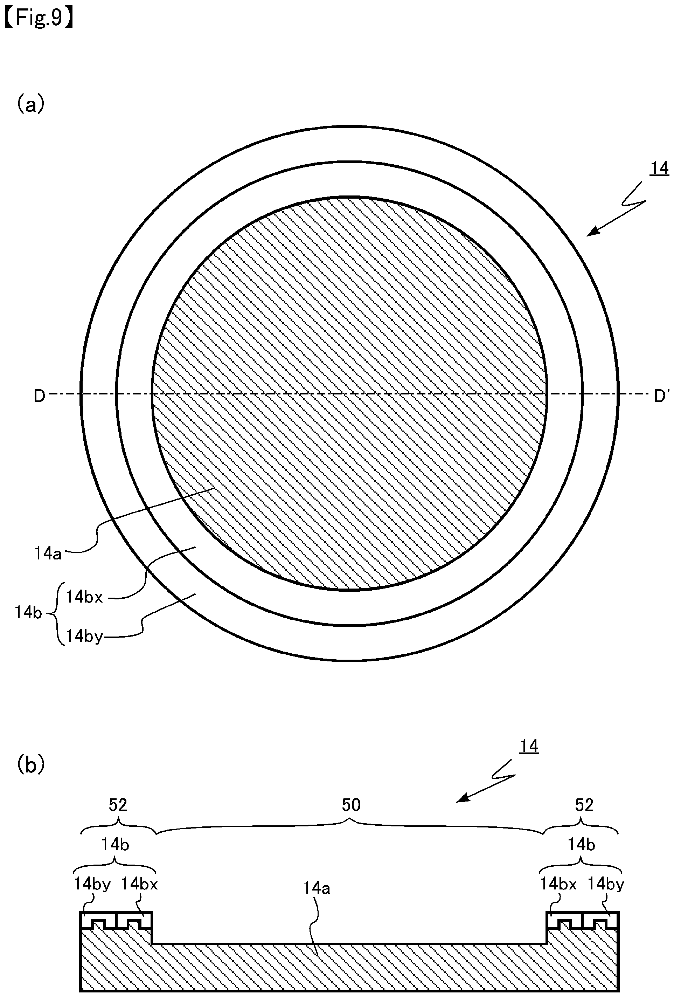

Fig. 9 is a schematic diagram of a holder according to the third embodiment. Fig. 9(a) is a top view, and Fig. 9(b) is a cross-sectional view taken along the line DD' of Fig. 9(a).

The annular member 14b has an annular shape. The annular member 14b has, for example, a circular ring shape. The annular member 14b is provided in the outer region 52. The annular member 14b is placed, for example, on the base member 14a in the outer region 52. The annular member 14b is placed, for example, on the outer periphery of the base member 14a in the outer region 52.

The annular member 14b includes a first member 14bx and a second member 14by. The first member 14bx and the second member 14by can be separated from each other. The first member 14bx and the second member 14by can be separated from the base member 14a.

Each of the first member 14bx and the second member 14by has, for example, an annular shape. Each of the first member 14bx and the second member 14by has, for example, a circular ring shape.

The second member 14by is provided, for example, on the outer side of the first member 14bx. For example, the second member 14by surrounds the first member 14bx.

On the outer periphery of the base member 14a, for example, two protrusions are provided as shown in Fig. 9(b). The position of the first member 14bx is fixed, for example, by fitting the first member 14bx to the protrusions inside the outer periphery of the base member 14a. In addition, the position of the second member 14by is fixed, for example, by fitting the second member 14by to the protrusions outside the outer periphery of the base member 14a.

In addition, the method of fixing the first member 14bx and the second member 14by is not limited to the method shown in Fig. 9(b).

The annular member 14b includes a portion containing non-oriented polycrystalline 3C-SiC on its surface.

The first member 14bx includes a portion containing non-oriented polycrystalline 3C-SiC on its surface. For example, at least the surface of the first member 14bx is formed of non-oriented polycrystalline 3C-SiC. For example, the first member 14bx is an example of a portion containing non-oriented polycrystalline 3C-SiC on its surface.

The first member 14bx is formed of, for example, a single material. For example, the first member 14bx is formed of non-oriented polycrystalline 3C-SiC.

The second member 14by includes a portion containing non-oriented polycrystalline 3C-SiC on its surface. For example, at least the surface of the second member 14by is formed of non-oriented polycrystalline 3C-SiC. For example, the second member 14by is an example of a portion containing non-oriented polycrystalline 3C-SiC on its surface.

The second member 14by is formed of, for example, a single material. For example, the second member 14by is formed of non-oriented polycrystalline 3C-SiC.

When forming a single crystal silicon carbide film on the surface of the wafer W placed on the susceptor 14, the silicon carbide film is formed on the surface of the first member 14bx and the surface of the second member 14by. Since the first member 14bx and the second member 14by contain non-oriented polycrystalline 3C-SiC on their surfaces, warpage of the first member 14bx and the second member 14by is suppressed. Therefore, for example, the first member 14bx and the second member 14by are prevented from being damaged due to stress.

However, if the silicon carbide film formed on the surface of the first member 14bx and the surface of the second member 14by becomes thick, the warpage of the first member 14bx and the second member 14by increases and accordingly, the first member 14bx and the second member 14by may be damaged by stress. In addition, if the silicon carbide film formed on the surface of the first member 14bx and the surface of the second member 14by becomes thick, the flow of the process gas when forming the silicon carbide film on the surface of the wafer W is disturbed and accordingly, the characteristics of the silicon carbide film on the surface of the wafer W may change.

Therefore, it is necessary to periodically remove the silicon carbide films formed on the surface of the first member 14bx and the surface of the second member 14by. The silicon carbide film formed on the surface of the first member 14bx and the surface of the second member 14by is removed by mechanical polishing outside the chamber 10, for example.

The annular member 14b according to the third embodiment includes the first member 14bx and the second member 14by that can be separated from each other. Since the annular member 14b can be separated into two members, for example, the surface area of a member to be polished by mechanical polishing can be reduced. Since the surface area of the member can be reduced, for example, damage to the member during mechanical polishing is suppressed. Therefore, the silicon carbide film formed on the surface of the annular member 14b can be easily removed.

### (Modification Example)

An annular member 14b according to a modification example of the third embodiment is different from the annular member 14b according to the third embodiment in that the first member 14bx includes a portion containing non-oriented polycrystalline 3C-SiC on its surface and the second member 14by does not include a portion containing non-oriented polycrystalline 3C-SiC on its surface.

The first member 14bx according to the modification example of the third embodiment includes a portion containing non-oriented polycrystalline 3C-SiC on its surface. For example, at least the surface of the first member 14bx is formed of non-oriented polycrystalline 3C-SiC. For example, the first member 14bx is an example of a portion containing non-oriented polycrystalline 3C-SiC on its surface.

The first member 14bx is formed of, for example, a single material. For example, the first member 14bx is formed of non-oriented polycrystalline 3C-SiC.

The second member 14by according to the modification example of the third embodiment does not include a portion containing non-oriented polycrystalline 3C-SiC on its surface. The second member 14by is formed of, for example, polycrystalline 4H-SiC, which is cheaper than polycrystalline 3C-SiC.

In the annular member 14b according to the modification example of the third embodiment, only the surface of the first member 14bx on the inner periphery is formed of polycrystalline 3C-SiC. By using polycrystalline 3C-SiC for the surface on the inner periphery that is easily damaged because the growth rate of the silicon carbide film formed on the surface is fast and warpage tends to increase, damage to the annular member 14b can be suppressed. Then, the cost of the annular member 14B can be reduced by forming the second member 14by on the outer periphery with inexpensive polycrystalline 4H-SiC.

In addition, it is also possible that the first member 14bx does not include a portion containing non-oriented polycrystalline 3C-SiC on its surface and the second member 14by includes a portion containing non-oriented polycrystalline 3C-SiC on its surface.

Up to now, the embodiments of the invention have been described with reference to specific examples. The above-described embodiments are merely given as examples and are not intended to limit the invention. In addition, the components of each embodiment may be combined as appropriate.

In the embodiments, the case of forming a single crystal silicon carbide film has been described as an example. However, the invention can also be applied to the formation of a polycrystalline or amorphous silicon carbide film. In addition, the invention can also be applied to the formation of a film other than the silicon carbide film.

In addition, in the embodiments, a wafer formed of single crystal silicon carbide has been described as an example of the substrate. However, the substrate is not limited to the wafer formed of single crystal silicon carbide.

In addition, in the embodiments, a single wafer type epitaxial growth apparatus has been described as an example of the vapor phase growth apparatus. However, the vapor phase growth apparatus is not limited to the single wafer type epitaxial growth apparatus.

In the embodiments, the description of portions that are not directly required for the description of the invention, such as an apparatus configuration or a manufacturing method, is omitted. However, the required apparatus configuration, manufacturing method, and the like can be appropriately selected and used. In addition, all vapor phase growth apparatuses that include the elements of the invention and that can be appropriately redesigned by those skilled in the art are included in the scope of the invention. The scope of the invention is defined by the scope of claims and the scope of their equivalents.

### EXPLANATIONS OF LETTERS OR NUMERALS

- 14: susceptor (holder)

- 14a: base member
- 14b: annular member (portion)
- 14bx: first member (portion)
- 14by: second member (portion)
- 50: inner region
- 52: outer region
- 100: vapor phase growth apparatus
- W: wafer (substrate)

## Claims

1. A holder, comprising:
a portion containing non-oriented polycrystalline 3C-SiC on its surface,
wherein a substrate can be placed on the holder.

2. The holder according to claim 1,
wherein, in the non-oriented polycrystalline 3C-SiC, when a diffraction peak intensity of a (111) face of the 3C-SiC obtained by Out-of-Plane XRD measurement is 100, the diffraction peak intensity of a (200) face of the 3C-SiC is 10 or more and 40 or less, the diffraction peak intensity of a (220) face of the 3C-SiC is 25 or more and 50 or less, and the diffraction peak intensity of a (311) face of the 3C-SiC is 15 or more and 65 or less.

3. The holder according to claim 2,
wherein, in the non-oriented polycrystalline 3C-SiC, when a diffraction peak intensity of a (111) face of the 3C-SiC obtained by the XRD measurement is 100, the diffraction peak intensity of a (400) face of the 3C-SiC is greater than 0, the diffraction peak intensity of a (331) face of the 3C-SiC is greater than 0, the diffraction peak intensity of a (420) face of the 3C-SiC is greater than 0, and the diffraction peak intensity of a (422) face of the 3C-SiC is greater than 0.

4. The holder according to claim 1, further comprising:
an inner region; and
an outer region with an annular shape surrounding the inner region and surrounding the substrate when the substrate is placed,
wherein the portion is provided in the outer region.

5. The holder according to claim 1, further comprising:
a base member; and
an annular member placed on an outer periphery of the base member,
wherein the annular member includes the portion.

6. The holder according to claim 5,
wherein the annular member includes a first member and a second member separable from the first member, and
at least one of the first member and the second member includes the portion.

7. The holder according to claim 6,
wherein the first member has an annular shape,
the second member has an annular shape, and
the second member surrounds the first member.

8. The holder according to claim 7,
wherein the first member includes the portion, and the second member does not include the portion.

9. A vapor phase growth apparatus, comprising:
the holder according to claim 1.
